# EUROPEAN PATENT APPLICATION

(11) **EP 0 747 958 A2**
(43) Date of publication of application: **11.12.1996**
(21) Application number: 96303326.1
(22) Date of filing: 13.05.1996
(51) Int. Cl.: H01L 27/07

(54) **Vertically stacked switched-emitter devices**

(30) Priority: 07.06.1995 US 480139
(71) Applicant: SGS-THOMSON MICROELECTRONICS, INC., Carrollton Texas 75006-5039 (US)
(72) Inventor: Frisina, Ferruccio, Battiati CT, (IT); Ferla, Giuseppe, 95100 Catania CT, (IT); Puzzolo, Santo, 95127 Catania CT, (IT); Zambrano, Raffaele, 95037 San Giovanni la Punta CT, (IT); Paparo, Mario, 95037 San Giovanni la Punta CT (IT); Blanchard, Richard A., Los Altos, California 94024 (US); Groover, Robert, Dallas, Texas 75248 (US)
(74) Representative: Palmer, Roger

(57) **Abstract**

A merged power device structure, of the emitter-switching type, in which the emitter of the bipolar power transistor has a minimum-width pattern which is aligned to the trenches of a trench control transistor. Thus the current density of the bipolar is maximized, since the emitter edge length per unit area is increased. The parasitic base resistance of the bipolar can also be reduced.

## Description

This application is related to European Patent Application No 96301273.7 the contents of which are incorporated herein by this cross-reference.

The present application relates to power transistor device structures.

Emitter switching is a circuit configuration in which a low-voltage power transistor (typically an MOS transistor) cuts off the emitter current of a high-voltage bipolar transistor whose base is connected to a fixed potential. Thus the bipolar's V_{BE} is controlled by varying the emitter potential in order to switch the bipolar on and off.

Numerous examples of such device configurations are shown in the applications cited above. In particular, patent 5,065,213 is a pioneering disclosure of switched-emitter device structures. In the primary embodiment described in this patent, a power bipolar transistor is overlaid with a VDMOS power device. The VDMOS device is a vertical-current-flow field-effect transistor which is easily switched by an insulated gate at its surface. The drain of the VDMOS device is a buried layer which ALSO functions as the emitter of a power bipolar device. Thus the on or off state of the VDMOS changes the potential of the bipolar device's emitter (hence the name of the device). The base of the bipolar device is another buried layer (surrounding and deeper than the emitter layer), which is held at constant potential. When the VDMOS is turned on, its conduction pulls up the drain/emitter diffusion. This forward biases the base/emitter junction to turn on the bipolar. Once the bipolar is turned on it provides a lower on-resistance per unit area than would a MOS transistor of the same breakdown voltage (due to bipolar conduction and associated regeneration gain). Thus this structure provides a uniquely advantageous improvement in the tradeoff between on-resistance Ron and breakdown voltage Vmax.

Switched-emitter configurations offer several advantages:
the negative temperature coefficient of a unipolar control transistor helps protect the bipolar transistor against reverse secondary breakdown (RSBOA);
the merged device combines the current and voltage carrying capacity of a bipolar transistor and the high speed of a low-voltage transistor;
the merged device can be piloted directly with linear logic circuits, through the MOS gate.
Thus merged device structure combines the advantages of a high-voltage bipolar transistor (low on-resistance and high-voltage withstand) with the advantages of power MOS (no secondary breakdown, voltage control, and fast turn-on and turn-off). This merged structure may be able to replace most discrete IGBT applications, and many discrete power MOS applications.

Various applications in the family have disclosed various improvements in the vertically-stacked switched-emitter structure, including: Use of a bipolar control transistor; Use of a trench control transistors, preferably aligned to a minimum-geometry patterned buried emitter layer; and use of heterojunction structures to provide a high-mobility control device.

The disclosed inventions will be described with reference to the accompanying drawings, which show important sample embodiments of the invention and which are incorporated in the specification hereof by reference, wherein:
FIG. 1 is a circuit diagram which shows the equivalent electrical circuit of the 4-terminals integrated structures, which the invention intends to realize;
FIGS. 2-7 are diagrammatic sections which show a structure according to the invention, in the vertical MOS power transistor version, during the various stages of the manufacturing process;
FIG. 8 is a section which shows the structure obtained at the end of the process referred to in the previous FIGS. 2-7;
FIG. 9 is a shows a diagram of the concentrations of the various types of doping agent along a section of the structure of FIG. 7;
FIG. 10 shows schematically an equivalent electrical circuit of an integrated circuit in accordance with the present invention in a 5-terminal version,
FIGS. 11-18 show schematically a structure at various stages of a manufacturing process for a superimposed components version in accordance with the present invention,
FIG. 19 shows schematically a 4-terminal structure at the end of the process represented by FIGS. 11-18,
FIG. 20 shows schematically a 5-terminal structure at the end of the process represented by FIGS. 11-18 with the addition of the sinker regions and the overlying contact Cp,
FIG. 21 shows schematically a profile of the concentrations of the various types of dopant along a section of the structure of FIG. 17,

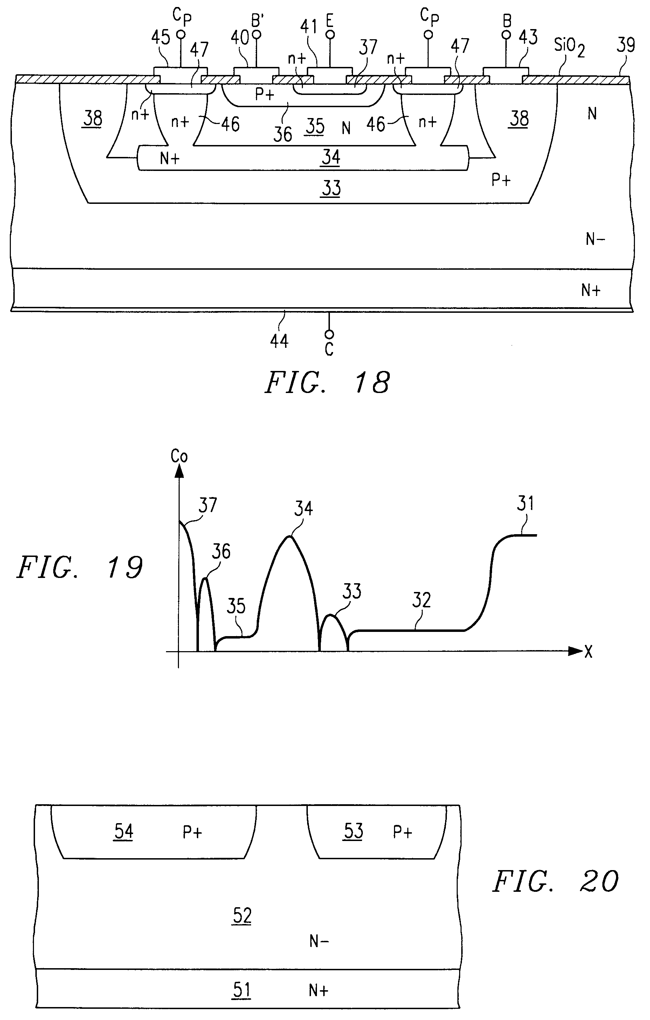

FIGS. 20-21 show schematically a structure during the various stages of a manufacturing process for an isolated components (not superimposed) version in accordance with the present invention, and

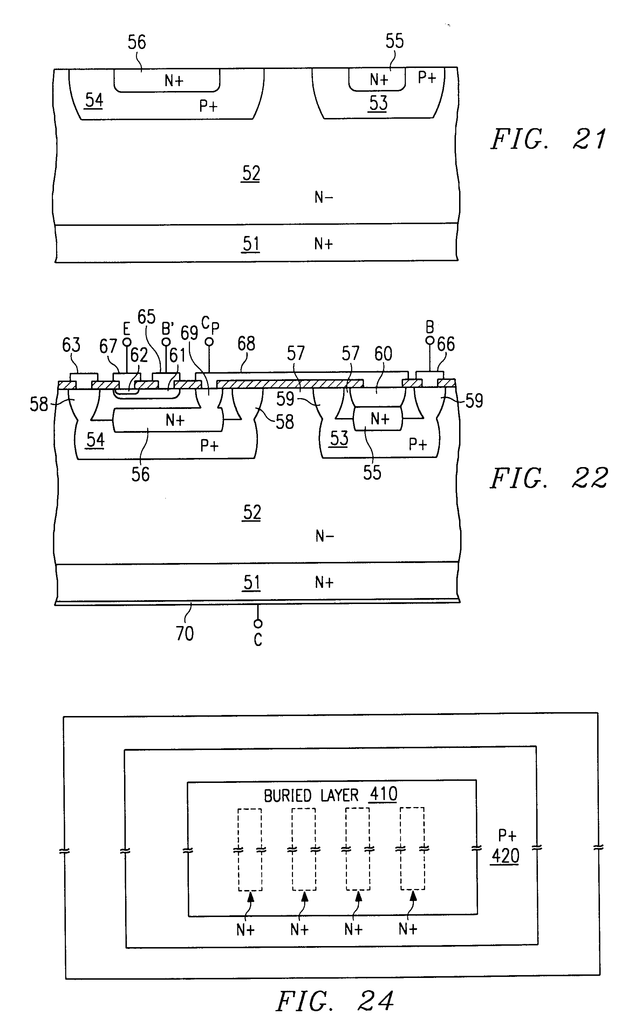

FIG. 22 shows schematically a structure at the end of the process represented by FIGS. 20-21.

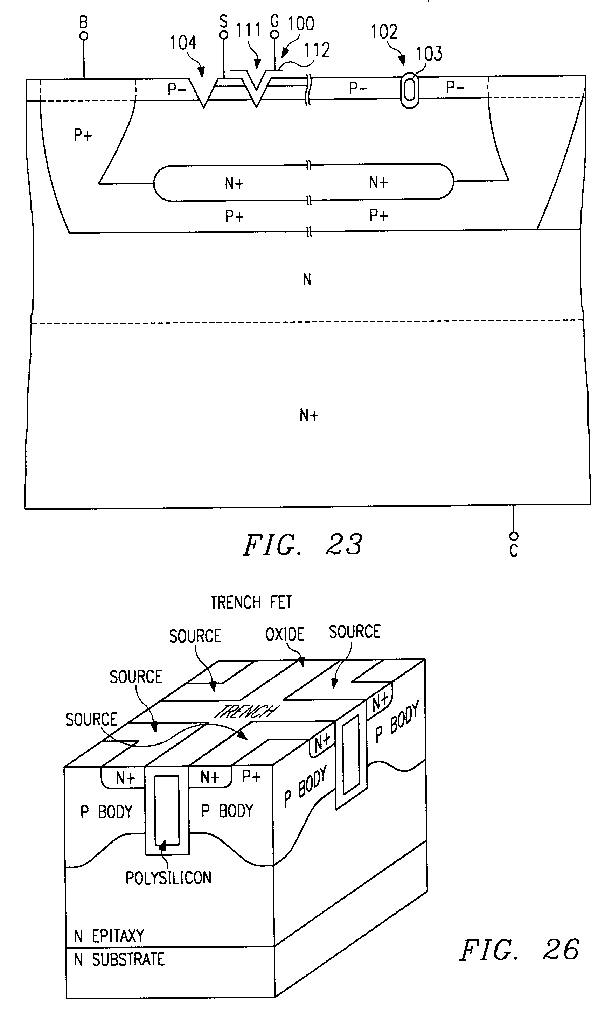

**Figure 23** is a cross-section which shows two more innovative embodiments.

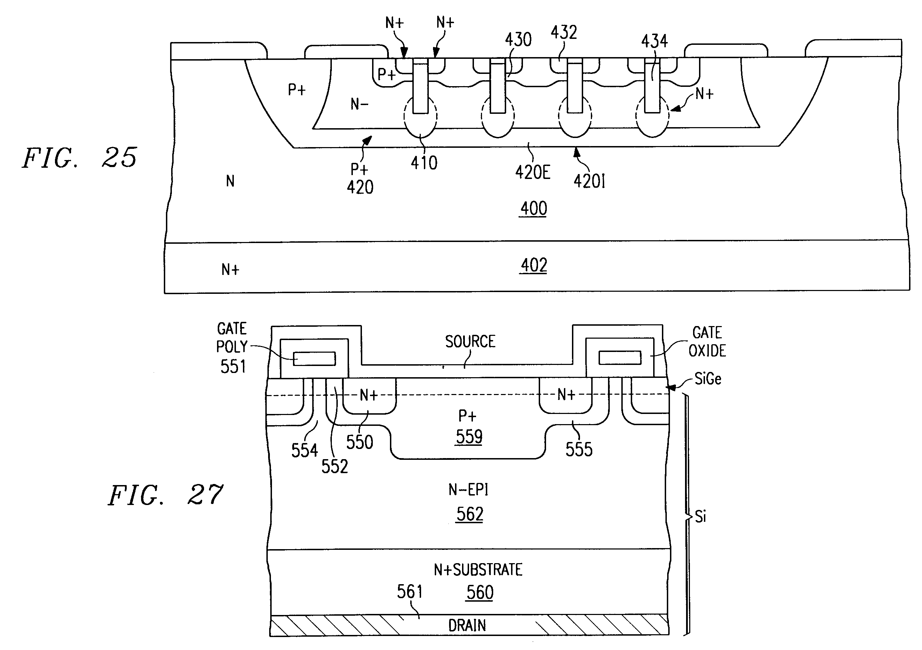

**Figure 24** shows a plan view of the bipolar portion of a switched-emitter transistor structure according to a sample embodiment of the present invention.
**Figure 25** is a sectional view of a switched-emitter transistor structure according to the present invention.
**Figure 26** is a detailed view of the trench MOS transistor in the structure of Figure 25.
**Figure 27** shows a further device structure according to the present invention. This is a VDMOS, in which the mobility of the channel regions, but not of the regions where JFET pinchoff occurs, has been increased.

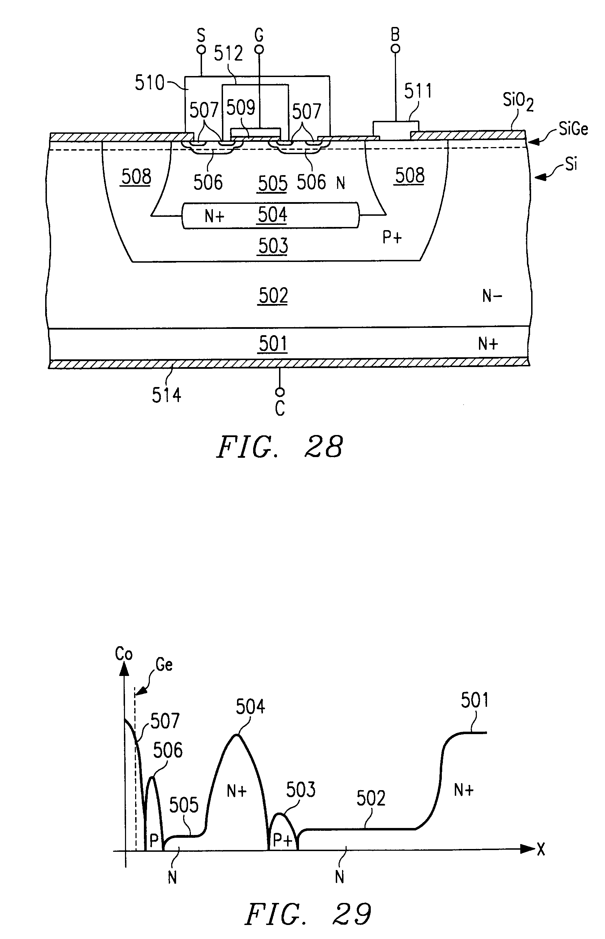

**Figure 28** shows a further sample device structure according to the present invention, in which a surface DMOS, with enhanced mobility, drives the emitter of a buried bipolar transistor which provides high-voltage withstand. **Figure 29** shows a sample doping profile for a vertical line through the structure of Figure 28.

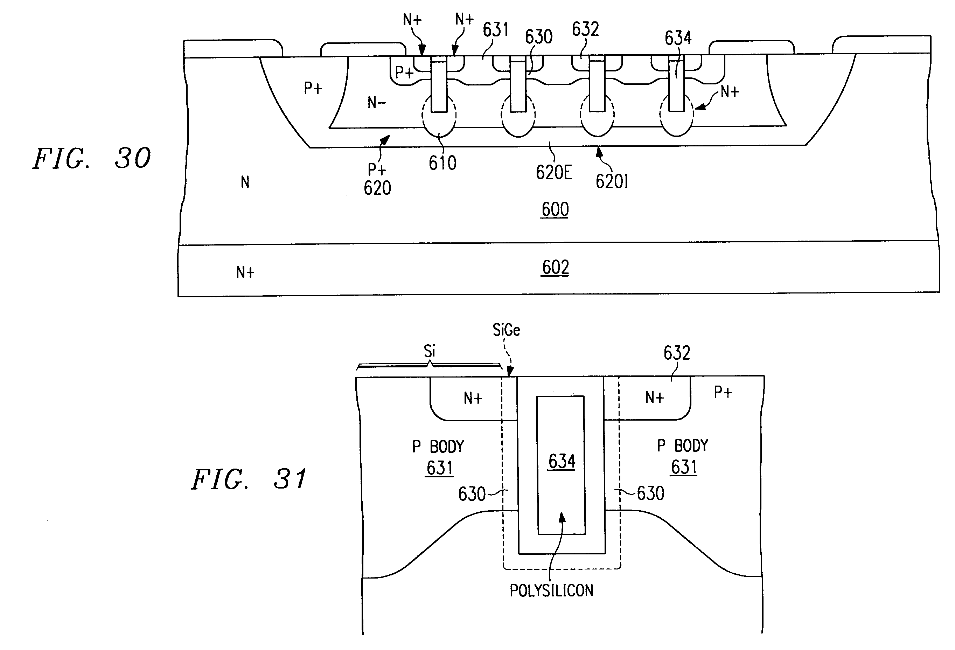

**Figure 30** shows a third sample device structure according to the present invention, and **Figure 31** shows a detail view of the trench transistor in Figure 30.

The numerous innovative teachings of the present application will be described with particular reference to the presently preferred embodiment (by way of example, and not of limitation), in which:

### Figures 1-9

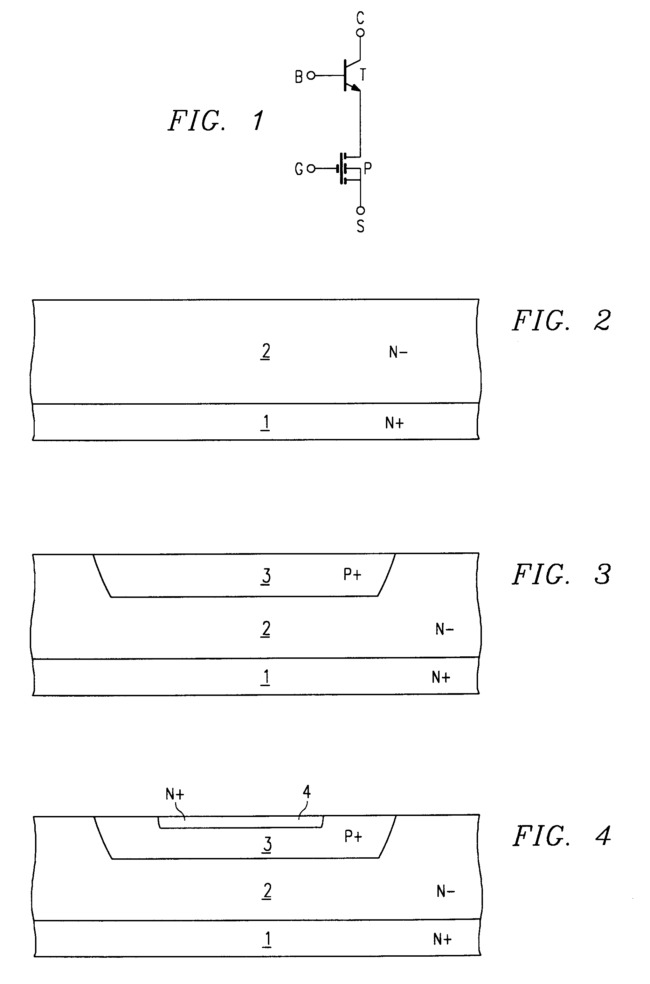

FIG. 1 shows the equivalent electrical circuit of the 4-terminal integrated structures that the invention intends to provide.

This circuit consists of a high-voltage bipolar power transistor T connected by means of its emitter to the drain of a low-voltage MOS power transistor P.

The various stages of the manufacturing process of the integrated structure, in the vertical MOS version, are described hereunder.

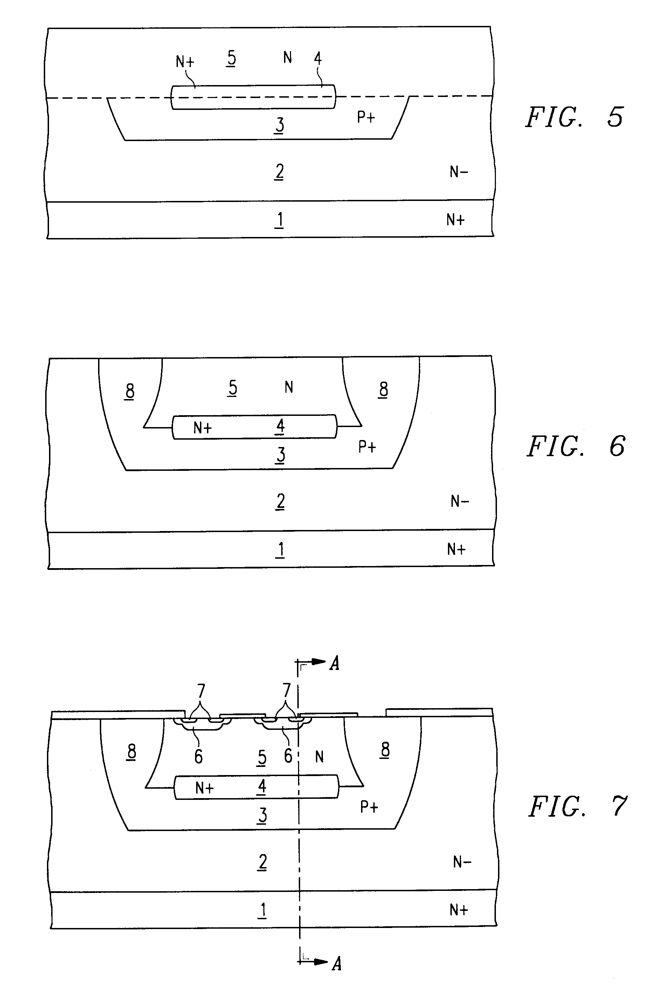

A first high resistivity N- conductivity epitaxial layer 2 is grown on an N+ type substrate 1 (FIG. 2). A P+ type region 3 is then obtained, by deposition or implantation and subsequent diffusion, on said layer 2 (FIG. 3). An N+ type region 4 is then obtained by means of the same process (FIG. 4). This is followed by the growth of a second N type epitaxial layer 5 (FIG. 5) and, by the known procedures of oxidation, photomasking, implantation and diffusion, the creation of the P+ type regions 8, which enable the region 3 constituting the base of the bipolar transistor to be connected on the surface (FIG. 6). A low-voltage vertical MOS power transistor and in particular the relative P conductivity body regions 6, N+ type source regions 7 (FIG. 7), the gate 9 and the metal coatings 10, 11 and 14 for ensuring the ohmic contact with the regions 6, 7, 8 and the substrate 1 (FIG. 8) are then created in the area between the two regions 8, according to known procedures.

FIG. 8 shows the final structure, as it appears after addition of the terminals C (collector), B (base), S (source) and G (gate) and the insulating layer 12 of the gate 9 (said gate being connected to the relative terminal by means of the insulated conductor 13). Regions 1, 2, 3 and 4 of the figure constitute, respectively, the collector, the base and the emitter of a bipolar transistor, while region 5 constitutes the drain of the MOS. Said drain is consequently connected directly to the emitter of the bipolar transistor thus forming a structure having as its equivalent circuit the circuit of FIG. 1.

The emitter 4 represents a completely buried N+ type active region; by growing a second N type epitaxial layer 5 it is thus possible to connect the drain of the MOS to the emitter 4 of the bipolar transistor.

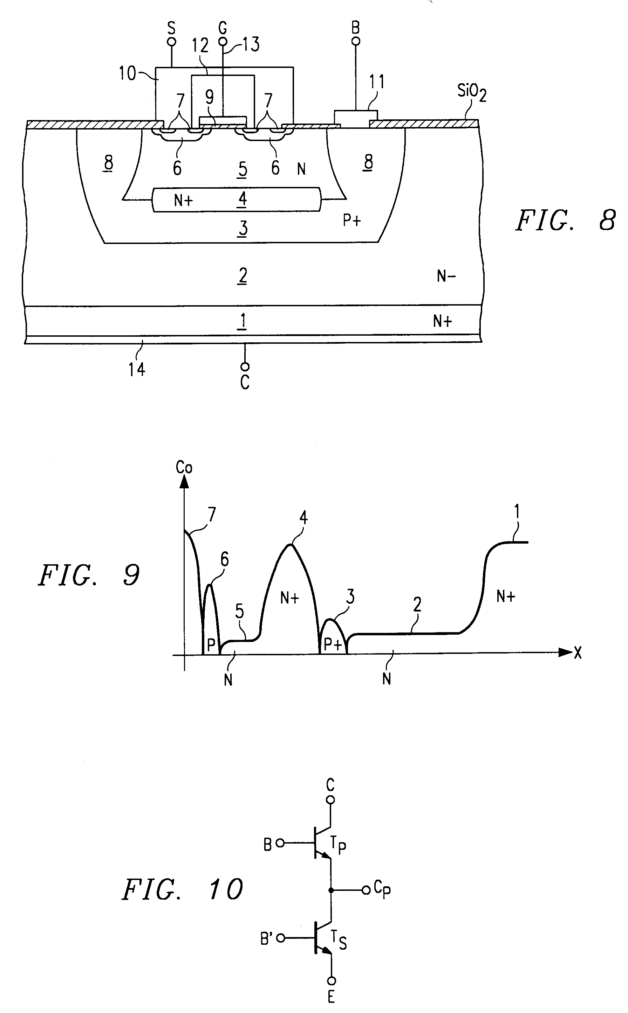

The profile of the concentration (Co) of the various types of doping agent in the different regions of the structure, along section A--A of FIG. 7, is shown in FIG. 9, where axis x refers to the distance from the upper surface of the structure.

### Figures 10-22

FIG. 10 shows an electrical circuit equivalent of the integrated structure in a 5-terminal version of the present invention. This circuit comprises a bipolar power transistor Tp connected through its own emitter to the collector of a low voltage bipolar transistor Ts. The electrode Cp for connection to the collector of the low voltage transistor Ts and the emitter of power transistor Tp is not necessary for the emitter switching configuration while it is essential for operation of the circuit in a semibridge configuration. In the semibridge configuration, a current flows in the node Cp in one direction or the opposite direction depending on the conduction state of the transistors Tp and Ts, which, in order to avoid shorting to ground, cannot be in conduction at the same time. However, the terminal Cp can also be present in an emitter switching configuration in order to take the voltage present at the collector of the low voltage transistor or to prevent full saturation of the low voltage transistor. Thus, as the emitter switching configuration can be either a 4-terminal version or a 5-terminal version, and as the 5-terminal version can be employed as either an emitter switching configuration or a semibridge configuration, the term "emitter switching configuration" shall be considered herein to be the generic term except as otherwise indicated by the context.

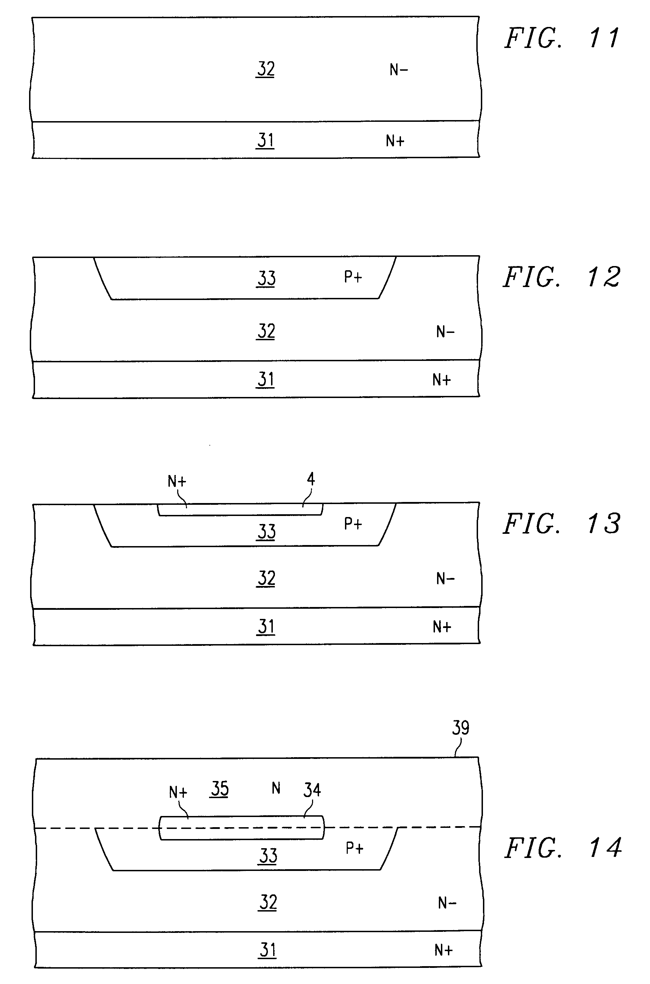

A manufacturing process for the integrated structure in the version with superimposed components not isolated from each other as shown in FIG. 8, will now be described in detail. As a first step, a first epitaxial layer 2 with N-conductivity and high resistivity is grown on a N+ type silicon substrate 1 (FIG. 11). The substrate 31 has a first face which is to be the back face of the semiconductor chip. The epitaxial layer 32 is grown on the face of the substrate 1 which is opposite to the back face. An ion implantation and subsequent diffusion process can then be employed to produce a P+ type region 33 on the side of the layer 32 which is remote from substrate 31 (FIG. 12). Similarly, an N+ region 34 (FIG. 13) can then be produced on the side of layer 33 which is remote from substrate 31.

In the next stage, a second epitaxial layer 35 of N type material (FIG. 14) is grown on the side of the structure which is remote from substrate 31, with layer 35 bridging the exposed surfaces of regions 32, 33, and 34. The formation of the N type layer 35 causes the N+ region 34 to expand into layer 35. Then, known oxidation, photomasking, implantation and diffusion processes are used to define the P+ regions 38, which are positioned about the periphery of region 33 and extend inwardly from the front face 39 of the chip until they reach the region 33 as illustrated in FIG. 15. The P+ regions 38 connect the P+ region 33, constituting the base of the bipolar power transistor Tp, to the surface 39 of the chip.

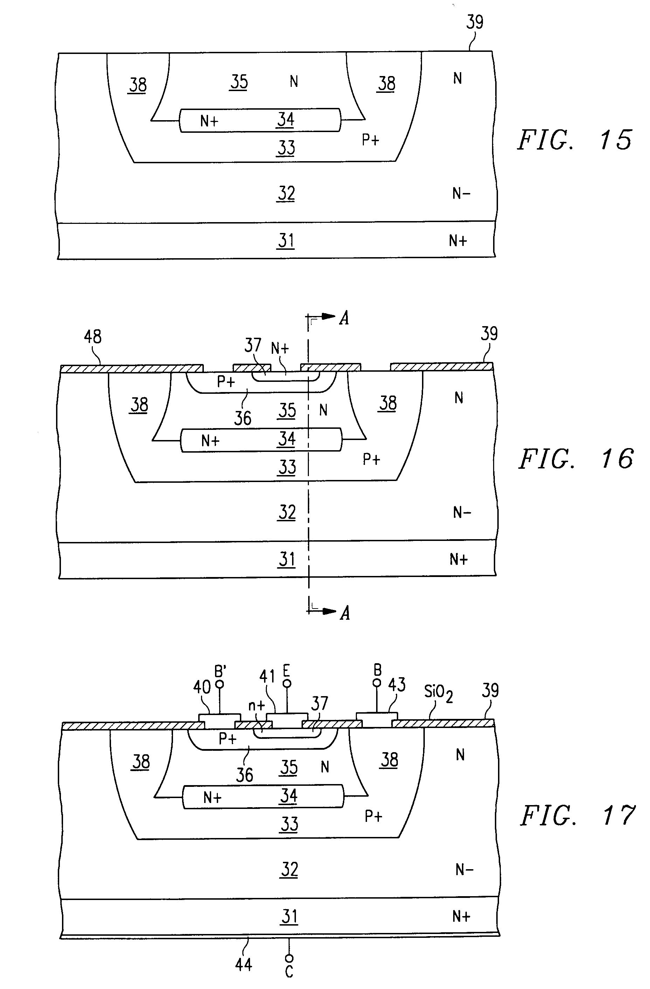

FIG. 16 shows the device after known techniques have been used to produce the P+ region 36, the N+ region 37, and the surface layer 48 containing thermal oxide SiO2. Region 36 and. 37 are formed in the portion of the second epitaxial layer 35 which is encircled by regions 34 and 38, with region 37 being at the front face of the chip and separated from the remainder of that portion of layer 35 by region 36. The portion of the second epitaxial layer 35 between region 34 and region 36 serves as the collector of the low voltage transistor Ts. The P+ region 36 and the N+ region 37 make up the base and emitter, respectively, of the bipolar NPN low voltage transistor indicated by Ts in the equivalent circuit of FIG. 10.

As shown in FIG. 16, the emitter of the power transistor Tp consists of the N+ region 34, which is completely buried. The collector 35 of the low voltage transistor Ts is thereby connected directly to the emitter 34 of the power transistor Tp. The combination of the substrate 31 and the remainder of the epitaxial layer 32 after the formation of regions 33 and 34 constitutes the collector of power transistor Tp.

Following the stage of FIG. 16, the metallizations 40, 41, 43 and 44 are deposited at their respective locations of the chip to ensure ohmic contact with the regions 36, 37, 38 and the substrate 31, respectively, and to constitute the terminals B', E, B and C, respectively, which correspond to the identically named terminals of FIG. 10.

The final structure resulting from the process described above is shown in FIG. 17. As illustrated in FIG. 17, the final structure is an emitter switching configuration circuit integrated in a single chip of semiconductor material. The chip has a front or top face and a back or bottom face, with the back face being the outer surface of substrate 31.

The original composite formed by substrate 31 and epitaxial layer 32 has been converted to a modified substrate having a back face and a second face opposite the back face, and having a first region 31, 32, a second region 33, and at least part of a third region 34, as such regions are illustrated in the "final" condition in FIG. 17. The first region 31, 32 in the modified substrate has a first type of conductivity, which in the illustrated embodiment is N type, and constitutes the collector of the power transistor Tp. The second region 33 in the modified substrate is at least partially contiguous to the second face of the modified substrate and is separated from the back face by the first region 31, 32. The second region 33 has a second type of conductivity which is opposite to that of the first region. In the embodiment illustrated in FIG. 17, this second type of conductivity is the P type. The second region 33 constitutes the base region of the power transistor Tp. the third region 4 is contiguous to the second face and is separated from the first region 31, 32 by the second region 33. The third region 34 has the first type of conductivity and constitutes the buried emitter of the power transistor Tp.

The surface of the second epitaxial layer, on the side thereof which is remote from the first epitaxial layer 32, serves as the front face of the semiconductor chip. The second epitaxial layer, which bridged the first region 32, the second region 33, and the third region 34 on the side thereof remote from the back face, has also been converted to a modified epitaxial layer containing a fourth region, at least one fifth region 38, and a sixth region. The fourth region has the first type of conductivity and is the portion of the original second epitaxial layer not converted to the fifth and sixth regions. The fifth region 38, having the second type of conductivity, extends inwardly from the front face of the chip and is connected to the peripheral contour of the second region 33 so as to collectively encircle the sixth region.

The sixth region is the portion of the original second epitaxial layer 35 which is collectively encircled by the second and fifth regions. The sixth region has three portions. The first portion of the sixth region has the first type of conductivity and constitutes the collector of the low voltage transistor Ts. The first portion of the sixth region separates the second portion of the sixth region from the third region 4, while the second portion of the sixth region separates the first portion of the sixth region from the third portion of the sixth region. The second portion 36 of the sixth region is at least partially contiguous to the front face of the chip, has the second type of conductivity, and constitutes the base of the low voltage transistor Ts. The third portion 37 of the sixth region is contiguous to the front face of the chip, has the first type of conductivity, and constitutes the emitter of the low voltage transistor Ts.

A first metallization 10 deposited on the front face of the chip is in contact with the second portion 36 of the sixth region and constitutes the base electrode B' of the low voltage transistor Ts. A second metallization 41 deposited on the front face of the chip is in contact with the third portion 37 of the sixth region and constitutes the emitter electrode E of the low voltage transistor Ts. A third metallization 43 deposited on the front face of the chip is in contact with the fifth region 38 and constitutes the base electrode B of the power transistor Tp. A fourth metallization 44 is deposited on the back face of the chip and constitutes the collector electrode C of the power transistor Tp.

If the structure of FIG. 17 is to be used in the semibridge configuration, it must be integrated with the regions which allow access through an added terminal Cp to the buried emitter region 34 of the power transistor Tp. For this purpose the manufacturing process described above can be modified as follows. After the steps which lead to the structure of FIG. 15, known photomasking, implantation and diffusion processes can be used to provide the N+ sinker regions (the regions 16 of FIG. 18) which extend inwardly from the front face surface of the chip until they reach the buried third region 34. The definition of the P+ region 6 (i.e., the second portion of the sixth region) and of the N+ reference numbers 37 and 46 (i.e., the third portion of the sixth region and the sinker regions) in FIG. 18, can then be carried out. The regions 47 are sinker enriched portions of sinkers 46 aimed at improving the contacts and reducing the electrical resistance of the sinker. After the last steps of metallization and provision of the electrodes, the resulting structure appears as shown in FIG. 18. The metallization 45 on the front face of the chip constitutes electrode Cp for connection through the sinker regions 46 to the region 34.

The profile of the concentration (Co) of the various types of dopant in the different regions of the structure, along the line A--A of FIG. 16, is illustrated in FIG. 19, where the distance from the upper surface of the chip is shown on the X axis.

A manufacturing process for forming a version of the integrated structure having isolated nonsuperimposed components calls for the following steps, illustrated in FIGS. 20-22. An N-epitaxial layer 52, with high resistivity is grown on an N+ type silicon substrate 51 (FIG. 20). The substrate 51 has a first face which is defined as the back face of the chip. The epitaxial layer 52 is grown on the face of the substrate 51 which is opposite the back face. Then known processes (e.g., deposition or implantation and subsequent diffusion) can be used to simultaneously create two P+ regions 53 and 54 at spaced apart locations on the face of the epitaxial layer 52 which is remote from substrate 21. Region 53 is designed to be the base of the power transistor Tp and the region 54 is designed for the formation of the isolation region of the low voltage transistor Ts.

The use of the same diffusion process to simultaneously form the regions 53 and 54 enables these regions to have the same junction depth. This has the effect of maximizing the current carrying capacity of the final device for a given operating voltage.

Known oxidizing, photomasking, deposition or implantation and subsequent diffusion processes are then used to form an N+ region 55 in the region 53. The N+ region 55 constitutes the emitter of the power transistor Tp. At the same time an N+ region 56 can be provided in the region 54 (FIG. 21). Region 56 is designed to act as the collector for the low voltage transistor Ts.

A N type epitaxial layer 57 is then grown, followed by the provision of a P+ region 58 (which is necessary for the isolation of the low voltage transistor Ts), and a P+ region 59 (which is necessary for the connection to the surface of the base region 53 of the power transistor Tp). N+ regions 60 and 69 are then provided for connection of the emitter region 55 of the power transistor Tp and the collector 56 of the low voltage transistor Ts, respectively, to the chip surface.

Subsequently, a P+ region 61 is formed for the base of the low voltage transistor Ts, and an N+ region 62 is formed for the emitter of the low voltage transistor Ts.

Finally the metallizations 63, 65, 66, and 67, designed to ensure ohmic contact with the underlying regions of semiconductor material and to constitute the electrode of the isolation region for low voltage transistor Ts and the electrodes B', B, and E, respectively, are deposited at their respective locations on the front face of the chip, while metallization 70 is deposited on the rear face of the chip to constitute the electrode C.

The aforesaid metallizations also call for the formation of a track 68 for the connection of the collector 56 of the low voltage transistor Ts to the emitter 55 of the power transistor Tp of FIG. 22, so as to provide a connection of the two transistors in the configuration of FIG. 10.

Thus the original composite formed by substrate 51 and epitaxial layer 52 has been converted to a modified substrate having a first region 51, 52, a second region 53, a third region 54, a fourth region 25, and a fifth region 26, as such regions are illustrated in the "final" condition in FIG. 12. The first region 21, 22 in the modified substrate has a first type of conductivity, which in the illustrated embodiment is the N type, and constitutes the collector of the power transistor Tp. The second and third regions are at least partially contiguous to the second face of the layer 22 at spaced apart positions. The fourth and fifth regions are also contiguous to the second face of the layer 22. The second region 23 in the modified substrate is separated from the back face by the first region 21, 22. The second region 23 has a second type of conductivity which is opposite to the first type of conductivity. In the embodiment illustrated in FIG. 12, this second type of conductivity is the P type. The second region 23 constitutes the base region of the power transistor Tp. The third region 24 has the second type of conductivity and constitutes the isolation region of the low voltage transistor Ts. The second region 23 is positioned between the first region 22 and the fourth region 25. The fourth region 25 has the first type of conductivity, and constitutes the emitter of the power transistor Tp. The third region 24 is positioned between the first region 22 and the fifth region 26. The fifth region 26 has the first type of conductivity and constitutes the collector of the low voltage transistor Ts.

The original second epitaxial layer, which bridged the first region 22, the second region 23, the third region 24, the fourth region 25, and the fifth region 26 on the side thereof remote from the back face, has also been converted to a modified epitaxial layer containing a sixth region 27, a seventh region 28, an eighth region 31, a ninth region 32, a tenth region 29, an eleventh region 30, and a twelfth region (39), as these regions are illustrated in FIG. 12.

The sixth region 27 has the first type of conductivity, and is the balance of the second epitaxial layer after the formation of the seventh through the twelfth regions. The seventh region 28 has the second type of conductivity and extends from the front face of the chip through the sixth region 27 to join the third region 24 along the peripheral contour of the third region 24. The eighth region 31 has the second type of conductivity and is positioned in the portion of the second epitaxial layer 27 which is surrounded by the seventh region 28. The eighth region 31 constitutes the base of the low voltage transistor Ts.

The ninth region 32, which has the first type of conductivity, is positioned on the side of the eighth region 31 which is remote from the back face. The ninth region 32 constitutes the emitter of the low voltage transistor Ts. The tenth region 29 has the second type of conductivity and is positioned in the second epitaxial layer 27, extending inwardly from the front face of the chip to join with the second region 23 along the peripheral contour of the second region 23, to carry the base of the power transistor Tp to the front face of the chip. The eleventh region 30, having the first type of conductivity, is positioned in the portion of the second epitaxial layer 27 which is surrounded by the tenth region 29, to bring the emitter region 25 of the power transistor Tp to the front face of the chip. The twelfth region 39 has the first type of conductivity and is positioned in the portion of the second epitaxial layer which is surrounded by the seventh region 28, to carry the collector region 26 of the low voltage transistor Ts to the front face of the chip.

Metallizations 37, 35, and 36, on the front face of the chip, are in contact with the ninth region 32, with the eighth region 31, and the tenth region 29, respectively, and constitute the emitter electrode E of the low voltage transistor Ts, the base electrode B' of the low voltage transistor Ts, and the base electrode B of the power transistor Tp, respectively. Metallization 40 on the back face of the chip constitutes the collector electrode C of the power transistor Tp. The metallic track 38 connects the eleventh region 30 to the twelfth region 39, to thereby connect the collector 26 of the low voltage transistor Ts to the emitter 25 of the power transistor Tp.

The final emitter switching structure requires therefore four terminals, of which three are on the front or upper surface of the chip and the fourth is on the back or lower surface of the chip.

The addition of terminal Cp at the metallization 38 permits the connection of the collector of the transistor Ts of FIG. 1 to an external circuit in the use of the pair of transistors Tp-Ts in a semibridge operation.

In both the configuration with superimposed components and the configuration with nonsuperimposed components, the terminal Cp can also be present in the emitter switching configuration in order to take the voltage present on the collector of low voltage transistor Ts, or to prevent full saturation of the low voltage transistor Ts through control of its base current (antisaturation circuit) and thus speed up its switching.

Numerous modifications, adaptations, variations and substitutions of components with other functionally equivalent ones are possible for the embodiments described above by way of illustration without thereby going beyond the protective scope of the present invention. For example, the growth of the first epitaxial layer on the substrate could be unnecessary if a substrate with characteristics equivalent to those of the substrata mentioned above (substrata 1 of FIGS. 2 and 21 of 10) is adopted after growth of the first epitaxial layer.

In addition, although the present invention is illustrated for a structure with NPN transistors, it also applies, with variations apparent to those skilled in the art, to structures with PNP transistor provided, in this latter case, that the process starts with a type P substrate. The processes described lend themselves naturally to the simultaneous production on the same integrated circuit chip of several pairs of bipolar transistors Tp and Ts. This finds application, for example, in semibridge structures for control of direct current or step motors (for which two pairs are sufficient) and for control of three-phase current motors (for which three pairs are needed).

In these cases all the transistors Tp are provided on the same substrate and therefor have a common collector terminal, while the electrodes of each pair provided on the front of the chip can be connected together and to the external circuitry depending on design requirements.

### Figure 23

**Figure 23** is a cross-section which shows both a first embodiment of the invention (on the left side) and a second embodiment (on the right side). In these embodiments, the vertical MOS device is built in a top p- epi layer, and is laterally dielectrically isolated from the sinker diffusions which make contact to the base of the bipolar transistor.

In the illustrated structure the field-effect device is located in the middle of the top p- epi layer. Only one VMOS transistor is illustrated, but of course an array of vertical-current-flow field-effect transistors (VMOS or otherwise) can be used instead of the single device shown.

The first embodiment of the invention (on the left side) uses V-grooves to provide this isolation, and the second embodiment of the invention (on the right side of this figure) uses a refilled trench. The transistor itself is preferably formed with the same silicon etch used to define the isolation.

If trench isolation is coupled with the use of a trench MOSFET for other purposes, then the use of a p-type epitaxial layer 6' becomes particularly attractive from a process point of view. (Similar considerations apply to the combination of V-groove isolation with VMOS transistors, although this combination is less compatible with current trends of process development.)

The process flow described above is modified, after the step of Figure 6, to form trenches 102 or grooves 104 in the epitaxial layer 130 as shown, either before or after source and/or gate formation. According to conventional methods, the isolation trenches 102 (or the isolation grooves 104) are refilled with e.g. oxide 103. Whichever kind of recess is used, the MOS transistors 111 are fabricated with insulated gates 112 which extend down into the recesses to provide capacitive coupling to the p- epi layer along the sidewalls of the groove.

In a sample embodiment, the P- epi layer 130 is between 0.8 and 3 microns thick, and is doped to a value in the range of 10¹⁵cm⁻³-10¹⁶cm⁻³. The grooves or trenches are preferably etched to a depth of at least 0.5µm greater than the epi layer.

The described process can obviously be used to simultaneously obtain, on the same chip, several pairs of bipolar and MOS transistors having a collector terminal in common and their base contacts, sources and gates connected to three respective common terminals by means of a metal coating carried out on the front of the chip at the end of the process.

Description of trench transistor fabrication processes can be found in the annual proceedings of the ISPSD conference (INTERNAT'L SYMPOSIUM ON POWER SC DEVICES AND ICS), all volumes of which are hereby incorporated by reference, and in the annual IEDM proceedings, years 1975-1994 of which are hereby incorporated by reference.

### Figures 24-26

**Figure 24** shows a plan view of the bipolar portion of a switched-emitter transistor structure according to a sample embodiment of the present invention, and **Figure 25** is a sectional view of a switched-emitter transistor structure according to the present invention.

The n+ emitter portions 410, in the presently preferred embodiment, have a pitch in the range of 10-15 µm and a minimum width of *e.g.* 3-4 µm. (The width is less than half the pitch in order to avoid current crowding between adjacent emitters.) The pitch, in the presently preferred embodiment, is limited by the n+ pitch rather than the trench pitch. (Minimum geometries for buried layers are typically larger than those of overlying structures.)

The dopant density (Q) for the buried layers is typically in the range of 5E14-5E16 cm⁻² for each (specifically e.g. 5 × 10¹⁵ cm⁻² for the P-type and 2 × 10¹⁶ cm⁻² for the N-type). Many bipolar structures use a heavier doping for the N-type buried layer (and this may be preferable in some implementations of the disclosed structure), but this is not strictly necessary for the practice of the present invention (emitter injection efficiency is not particularly a concern). The P-type doping density is preferably selected to provide a low sheet resistance in the extrinsic base 420E while retaining base width control; the N-type dopant density is preferably selected to provide counterdoping of the P-type dopants, and to provide a heavier doping on the emitter side of the emitter/base junction.

Boron is preferred for the p-type buried layer 420. (The greater diffusivity of Boron, as opposed to gallium, would provide greater counterdoping, hence a greater ratio of extrinsic base width to intrinsic base width.) A slow diffusing dopant (As or Sb) is preferred for the n-type buried layer, but phosphorus can also be used.

The length of the channel 410 of the trench FET, in the presently preferred embodiment, is selected to withstand only a moderate voltage (e.g. about 20V, which implies a channel length of about 0.5 to 1 µm with typical epitaxial layer doping levels. The epitaxial layer thickness can accordingly be e.g. 5 to 10 microns.

The source 432 is shallow and doped N+.

The gate 434 of the trench FET is, e.g., N+ polysilicon.

A clamp diode is preferably used to protect the switched-emitter structure when inductive loads must be driven.

The minimum intrinsic base thickness in this type of structure is selected in accordance with the desired gain and ruggedness, but is typically in the range of 1-4 µm. Larger base widths imply lower gain but greater ruggedness.

The bipolar transistor is preferably be a fairly low-gain device, e.g. beta of 20-100. (The beta is controlled by selecting the base width; lower base widths produce higher gain, but transistors with lower beta are typically more rugged.)

Typical operating voltages on this structure may be, e.g., 3V constant base voltage (optionally fed through a load impedance); 0V source voltage on the control device; gate voltage switched between e.g. 0V and e.g. 10V; collector voltage 500V. Of course a wide variety of different operating voltages can be specified, with or without modifications to optimize the device structure, but this example will help to illustrate the advantages of the disclosed structure.

**Figure 26** is a detailed view of a sample implementation of the trench MOS transistor in the structure of Figure 2. Details of this implementation are described in Goodenough, "Trench-Gate DMOS FETs In SO-8 Switch 10A at 30V," in the March 6, 1995 issue of Electronic Design at 65, which is hereby incorporated by reference. (Of course many other implementations are possible; see e.g. patents 4,893,160 and 4,914,058, both of which are hereby incorporated by reference.)

### Figures 27-31

### Background: Silicon/Germanium Processing

Germanium is a semiconductor material which has a narrower bandgap, and more nearly equal electron and hole mobilities, than silicon. Much of the earlier transistor work used germanium, but silicon completely replaced germanium in the mainstream of semiconductor development in the 1960s. Thereafter there was little work on germanium materials until around 1990, when a significant amount of effort began to be devoted to development of fabrication processes using silicon/germanium ("SiGe") alloys.

Silicon is superior to germanium in the quality of a grown oxide interface. Moreover, a grown germanium oxide may be water-soluble. However, oxides grown on SiGe alloys with small germanium concentrations (below about 25-30% Ge) largely avoid these problems, and are very nearly as good as the oxide on pure silicon.

One important attraction of silicon/germanium alloys is that they permit the advantages of bandgap engineering to be obtained with conventional silicon processing. *See e.g.* King *et al*., "Deposition and properties of low-pressure chemical-vapor deposited polycrystalline silicon-germanium films," 141 J. ELECTROCHEMICAL SOCIETY 2235 (1994); Caymax *et al*., "Low temperature selective growth of epitaxial Si and Si₁₋ₓGeₓ layers from SiH₄ and GeH₄ in an ultrahigh vacuum, very low pressure chemical vapour deposition reactor: kinetics and possibilities," 241 THIN SOLID FILMS 324-8 (1994); King *et al*., "Electrical properties of heavily doped polycrystalline silicon-germanium films," 41 IEEE TRANS'NS ELECTRON DEVICES 228 (1994); Johnson *et al*., "Selective chemical etching of polycrystalline SiGe alloys with respect to Si and SiO₂," 21 J. ELECTRONIC MATERIALS 805 (1992); Verdonckt-Vandebroek *et al*., "SiGe-channel heterojunction p-MOSFET's," 41 IEEE TRANS'NS ELECTRON DEVICES 90 (1994); Caymax *et al*., "UHV-VLPCVD heteroepitaxial growth of thin SiGe-layers on Si-substrates: influence of pressure on kinetics and on surface-morphology," 32-33 DIFFUSION AND DEFECT DATA B 361 (1993); Hsieh *et al*., "Ambipolar performances of novel amorphous silicon-germanium alloy thin-film transistors," 32 JAPANESE J. APPLIED PHYSICS PART 2 (Letters) at L1043 (1993); Kesan *et al*., "High performance 0.25 µm p-MOSFETs with silicon-germanium channels for 300 K and 77 K operation," 1991 IEDM TECHNICAL DIGEST 25; Verdonckt-Vandebroek *et al*., "Design issues for SiGe heterojunction FETs," PROC. IEEE/CORNELL CONFERENCE ON ADVANCED CONCEPTS IN HIGH SPEED SEMICONDUCTOR DEVICES AND CIRCUITS 425 (1991); Verdonckt-Vandebroek *et al*., "High-mobility modulation-doped SiGe-channel p-MOSFETs," 12 IEEE ELECTRON DEVICE LETTERS 447 (1991); Selvakumar *et al*., "SiGe-channel n-MOSFET by germanium implantation," 12 IEEE ELECTRON DEVICE LETTERS 444 (1991); Humlicek *et al*., "Optical spectra of SiₓGe₁₋ₓ alloys," 65 J. APPLIED PHYSICS 2827 (1989); Prokes *et al*., "Formation of epitaxial Si₁₋ₓGeₓ films produced by wet oxidation of amorphous SiGe layers deposited on Si(100)," 53 APPLIED PHYSICS LETTERS 2483 (1988); Hamakawa *et al*., "Recent advances in amorphous silicon solar cells and their technologies," 59-60 J. NON-CRYSTALLINE SOLIDS 1265 (1983). These articles, and all of the references cited in them, are all hereby incorporated by reference.

### First Device Embodiment: VDMOS

**Figure 27** shows a second sample device structure according to the present invention. This is a VDMOS, in which the mobility of the channel regions 552, but not of the regions 554 where JFET pinchoff occurs, has been increased. The dashed horizontal line indicates the approximate boundary between the SiGe_{.1} material, in the presently preferred embodiment, and the pure silicon. However, a too-shallow boundary makes process control more difficult (especially in relation to control of oxide growth). This structure operates conventionally (except that the current density is increased); *i.e.* the potential of insulated gate 551 controllably pulls the channel 552 into accumulation, and thereby permits electrons to flow from source 550 down through the N-type epitaxial layer 562 and N-type substrate 560 to a backside drain contact 561. The channel 552 is formed by a surface portion of the P-type body diffusion 552. Deep body diffusion 559 provides added JFET gating for high-voltage withstand.

### Second Device Embodiment: Switched-Emitter with DMOS Control Device

**Figure 28** shows a second sample device structure according to the present invention, in which a surface DMOS, with enhanced mobility, drives the emitter of a buried bipolar transistor which provides high-voltage withstand. In the illustrated example the surface DMOS is a VDMOS, but of course this can be varied. The dashed line indicates the approximate boundary between the SiGe_{.1} material, in the presently preferred embodiment, and the pure silicon. In this embodiment this boundary is indicated as lying below the source junction, but alternatively this could be as shallow as the source junction depth, or even shallower. (Ultimately the relevant depth is the depth of the accumulation region when the device is fully turned on, and some benefit will still be obtained if bandgap gradation occurs within this depth.)

In this structure, the connections to external terminals C (collector), B (base), S (source) and G (gate) are indicated. The insulating layer 512 separates the gate 509 from the source metallization 10. Regions 501, 502, 503 and 504 of the figure constitute, respectively, the collector, the base and the emitter of a bipolar transistor, while region 505 constitutes the drain of the MOS.

Switched-emitter devices, like IGBTs, preferably use clamping diodes when used with inductive loads.

**Figure 29** shows a sample doping profile for a vertical line through the structure of Figure 28. Germanium fraction is shown with a dotted line, since germanium is not a dopant (strictly speaking). The lateral dimensions of this figure are not to scale, but this figure does give some indication of relative dopant levels.

### Third Device Embodiment: Switched-Emitter with Trench Transistor Control Device

**Figure 30** shows a third sample device structure according to the present invention. This is another switched-emitter structure, but in this case the control device is a trench transistor with enhanced mobility. Due to the scale required, this drawing does not explicitly show the bandgap variation, but this is shown in the detail view of Figure 31.

The n+ emitter portions 610, in the presently preferred embodiment, have a pitch in the range of 10-15 µm and a minimum width of *e.g.* 3-4 µm. (The width is less than half the pitch in order to avoid current crowding between adjacent emitters.) The pitch, in the presently preferred embodiment, is limited by the n+ pitch rather than the trench pitch. (Minimum geometries for buried layers are typically larger than those of overlying structures.)

The dopant density (Q) for the buried layers is typically in the range of 5E14-5E16 cm⁻² for each (specifically e.g. 5 × 10¹⁵ cm⁻² for the P-type and 2 × 10¹⁶ cm⁻² for the N-type). Many bipolar structures use a heavier doping for the N-type buried layer (and this may be preferable in some implementations of the disclosed structure), but this is not strictly necessary for the practice of the present invention (emitter injection efficiency is not particularly a concern). The P-type doping density is preferably selected to provide a low sheet resistance in the extrinsic base 620E while retaining base width control; the N-type dopant density is preferably selected to provide counterdoping of the P-type dopants, and to provide a heavier doping on the emitter side of the emitter/base junction.

Boron is preferred for the p-type buried layer 620. (The greater diffusivity of Boron, as opposed to gallium, would provide greater counterdoping, hence a greater ratio of extrinsic base width to intrinsic base width.) A slow diffusing dopant (As or Sb) is preferred for the n-type buried layer, but phosphorus can also be used.

The length of the channel 630 of the trench FET, in the presently preferred embodiment, is selected to withstand only a moderate voltage (e.g. about 20V, which implies a channel length of about 0.5 to 1 µm with typical epitaxial layer doping levels. The epitaxial layer thickness can accordingly be e.g. 5 to 10 microns. The channel 630 is provided by the portion of p-type body diffusion 631 which is nearest the trench (and hence can be gated by trench gate 634).

The source 632 is shallow and doped N+.

The gate 634 of the trench FET is, e.g., N+ polysilicon.

A clamp diode is preferably used to protect the switched-emitter structure when inductive loads must be driven.

The minimum intrinsic base thickness in this type of structure is selected in accordance with the desired gain and ruggedness, but is typically in the range of 1-4 µm. Larger base widths imply lower gain but greater ruggedness.

The bipolar transistor is preferably be a fairly low-gain device, e.g. beta of 20-100. (The beta is controlled by selecting the base width; lower base widths produce higher gain, but transistors with lower beta are typically more rugged.)

Typical operating voltages on this structure may be, e.g., 3V constant base voltage (optionally fed through a load impedance); 0V source voltage on the control device; gate voltage switched between e.g. 0V and e.g. 10V; collector voltage 500V. Of course a wide variety of different operating voltages can be specified, with or without modifications to optimize the device structure, but this example will help to illustrate the advantages of the disclosed structure.

As seen in the detail view of Figure 31, a region of SiGe alloy exists along the walls of the trench, and thus the channel regions 630 are located in a region of higher mobility.

### First Process Embodiment: Shallow Epitaxial Growth

There are several process options in constructing the innovative devices. The simplest approach is simply to epitaxially grow a thin layer of SiGe, e.g. SiGe_{.1} to a thickness in the range of 100-5000Å (preferably e.g. 1000Å). This is preferably performed on a naked wafer, but optionally can be performed after a LOCOS-patterned field oxide has been grown (since the wider-bandgap material is preferred under the field oxide). Optionally n-wells and p-wells, if desired, can also be formed before the epitaxial growth.

(Optionally a brief silicon epitaxy can be performed after the SiGe epitaxy (e.g. to 300Å), to facilitate the subsequent growth of a gate oxide which is predominantly SiO₂. Depending on the thickness of this overgrowth a reverse bandgap gradation may occur near the surface, but this can be tolerated as long as lower-bandgap portions dominate the depth of the channel accumulation layer.)

After these initial steps, the rest of the process uses normal transistor fabrication steps, for whatever mix of devices is desired, which are entirely conventional and well-known.

### Second Process Embodiment: Deep Epitaxial Growth

This embodiment is generally less preferable, due to greater process complexity and defect density. However, this may be preferred for other reasons. Also, this is the most straightforward way (although not contemplated as the most preferable) to construct a switched-emitter device with trench FET control devices. In this case the SiGe epitaxy would be made thick enough to extend down to the drain of the trench transistor, e.g. 2 µm thick.

### Third Process Embodiment: Sidewall Epitaxial Growth

This is a more preferable way to fabricate device embodiments with a trench control transistor. In this process embodiment a short SiGe epitaxial growth step, as described in the first process embodiment above, is performed after the trenches have already been etched. (The epitaxial growth thickness is less than 1/4 of the ultimate minimum trench width, and more preferably less than 1/10 thereof.) This provides a high current density in the trench FETs (which is where the limit on current density arises), without requiring a long epitaxial growth step. This process also provides good compatibility with use of the epitaxial layer for other devices, e.g. CMOS.

### Fourth Process Embodiment: Implantation and Annealing

In this embodiment an implant of Ge is performed with a dose in the range of e.g. 5E17 to 1E19 cm⁻² and an energy selected to provide a stopping distance in the range of 100 to 500Å. After annealing this provides a lower-bandgap surface portion as desired.

### Modifications and Variations

As will be recognized by those skilled in the art, the innovative concepts described in the present application can be modified and varied over a tremendous range of applications, and accordingly the scope of patented subject matter is not limited by any of the specific exemplary teachings given. For example, as will be obvious to those of ordinary skill in the art, other circuit elements can be added to, or substituted into, the specific circuit topologies shown.

## Claims

1. A merged power transistor structure comprising:
a first active device located near a first surface of a monolithic semiconductor body, and providing conduction between said first surface and a first buried layer of a first conductivity type; and
a second active device located within said monolithic body beneath said first transistor, and providing bipolar conduction between said first buried layer and a second surface of the monolithic body;
whereby said first active device provides control of current, and said second active device provides high-voltage standoff with low on-resistance.
